Europäisches Patentamt

European Patent Office

Office européen des brevets

(11) Publication number: **0 179 298**
**B1**

(12) **EUROPEAN PATENT SPECIFICATION**

(45) Date of publication of patent specification: **09.08.89**

(21) Application number: **85112162.4**

(22) Date of filing: **25.09.85**

(51) Int. Cl.⁴: **G 12 B 17/02,** G 01 R 1/18,
H 05 K 9/00

(54) A method of eliminating the influence on one or more persons or animals from a magnetic field generating source and a device for eliminating such influence.

(30) Priority: **09.10.84 DK 4828/84**
**22.01.85 DK 293/85**

(43) Date of publication of application:
**30.04.86 Bulletin 86/18**

(45) Publication of the grant of the patent:
**09.08.89 Bulletin 89/32**

(84) Designated Contracting States:
**AT BE CH DE FR GB IT LI LU NL SE**

(56) References cited:
**DE-A-2 931 382**
**DE-B-2 146 071**

(73) Proprietor: **Berthelsen, Viggo**
**Lundely 14**
**dk-2900 Hellerup (DK)**

(72) Inventor: **Berthelsen, Viggo**
**Lundely 14**
**dk-2900 Hellerup (DK)**

(74) Representative: **Eisenführ & Speiser**
**Martinistrasse 24**
**D-2800 Bremen 1 (DE)**

Courier Press, Leamington Spa, England.

## Description

The present invention relates to the therapeutic or prophylactic field.

Generally, it is realized that human beings as well as other living creatures are to a great extent exposed to illness or disease causing effects from a great number of natural as well as artificial sources. The influence from biological and chemical sources is greatly realized and the specific effect of certain biological and chemical products is to a great extent proved. The effect of physical influences has far less been proved, although the effect of radioactive influence, of sonic and electro-magnetic influence and of extreme mechanical influences is to some extent realized. Most surprising, the effect of electro-magnetic influence has gained little interest. Generally, it is assumed that a magnetic field, either a stationary magnetic field or an alternating magnetic field, has no influence on human beings or on other living creatures. This assumption is probably based on the conjecture that human beings as well as other living creatures are not influenced by magnetic field generating sources since they have survived for generations on earth while exposed to the geomagnetic field. However, since the effect of the geomagnetic field on some animals, viz. migratory birds navigating on the basis of the geomagnetic field, has been realized this conjecture is probably not absolutely correct. Some experiments have proved an illness or diesease causing effect from electro-magnetic field influences.

From DE—A—29 31 382 and DE—B—21 46 071 it is known to screen or protect sensitive measuring equipment from magnetic fields by providing conductive short-circuit rings around the object to be protected. Additionally, from DE—B—21 46 071 it is known to apply compensating electromagnetic fields of proper amplitudes to avoid heavy short-circuit rings. But no mention is being made to use a similar effect for protecting living creatures from magnetic fields.

Therefore, it is an object of the present invention to provide a method of eliminating the influence on one or more persons or animals from a magnetic field generating source and of protecting said one or more persons or animals against the magnetic field generated by the magnetic source so as to eliminate the illness or disease causing effect of the source on said one or more persons or animals.

This object is obtained by a method according to the present invention comprising arranging a ring-shaped conductor of high electric conductivity so as to encircle the source, or alternatively, arranging the ring-shaped conductor in a plane between the source and said one or more persons or animals to be protected.

It is realized that the ring-shaped conductor may to a great extent eliminate the influence from the electro-magnetic field generating source when arranged at the source itself, i.e. so as to encircle the source, or arranged in a plane between the source and the persons or animals to be protected or otherwise exposed to the magnetic field generated by the source.

In accordance with the teaching of the present invention, it is realized that a highly advantageous magnetic field eliminating and protecting effect is obtained by arranging a number of ring-shaped conductors together constituting a network in said plane between the source and said one or more persons or animals to be protected or in said plane adjacent to said one or more persons or animals to be protected.

In accordance with this aspect of the present invention, the number of ring-shaped connectors are preferably connected to one another in electrically conductive relationship, although the number of ring-shaped connectors may alternatively be insulated relative to one another.

It is mandatory to the electro-magnetic field eliminating and protecting effect that the conductor or conductors exhibit high electrical conductivity. Thus, the material of the conductor or conductors are preferably selected from silver, copper or aluminium. By arranging the substantially ring-shaped conductor so as to encircle the source, the conductor is preferably arranged closely adjacent to the source in order to obtain a maximum field eliminating and protecting effect. Consequently, the overall dimension of the ring-shaped conductor depends to a great extent on the dimensions of the source in question. However, in accordance with the teaching of the present invention it is realized that said ring-shaped conductor or said number of ring-shaped conductors preferably define a perimeter of less than 2 m, preferably less than 1.5 m, and are constituted by a copper conductor of a section area of more than 1.5 mm$^2$ such as 5 mm$^2$.

The method according to the invention is applicable to natural sources such as the geomagnetic field source as well as artificial sources such as an electrical apparatus or a component thereof, such as an electric motor or transformer, a cathode-ray tube of a television set or of a computer terminal, a domestic apparatus, such as a washing machine, a rotary dryer, an automatic dishwasher, a vacuum cleaner, an electric heating apparatus, an electrodynamic loudspeaker unit, a light source, particularly a fluorescent light source, lamp or tube, or the like.

The present invention further relates to a device for eliminating the influence on one or more persons or animals from a magnetic field generating source and for protecting said one or more persons or animals from the magnetic field generated by the magnetic source so as to eliminate the illness or disease causing effect of the source to said one or more persons or animals. In accordance with the teaching of the present invention, the device comprises a closed loop conductor of high electrical conductivity adapted to be arranged so as to encircle the source, or alternatively adapted to be arranged in the plane between the source and said one or more persons or animals to be protected.

The invention will now be further described with reference to the drawings, in which,

Figure 1 is a schematical and perspective view of a computer terminal in which a device according to the invention is included,

Figure 2 is a schematical and perspective view of an accessory embodiment of the device according to the invention,

Figure 3 is a schematical and perspective view of a cathode-ray tube including two devices according to the invention,

Figure 4 is a schematical and perspective view of an electrodynamic cone loudspeaker unit including two devices according to the invention,

Figure 5 is a schematical and perspective view of a domestic apparatus in which a motor is provided with a device according to the invention,

Figure 6 is a schematical and perspective view of a fluorescent lighting fitting, and

Figure 7 is a schematical and perspective view of a lighting fitting for outdoor use and including fluorescent tubes.

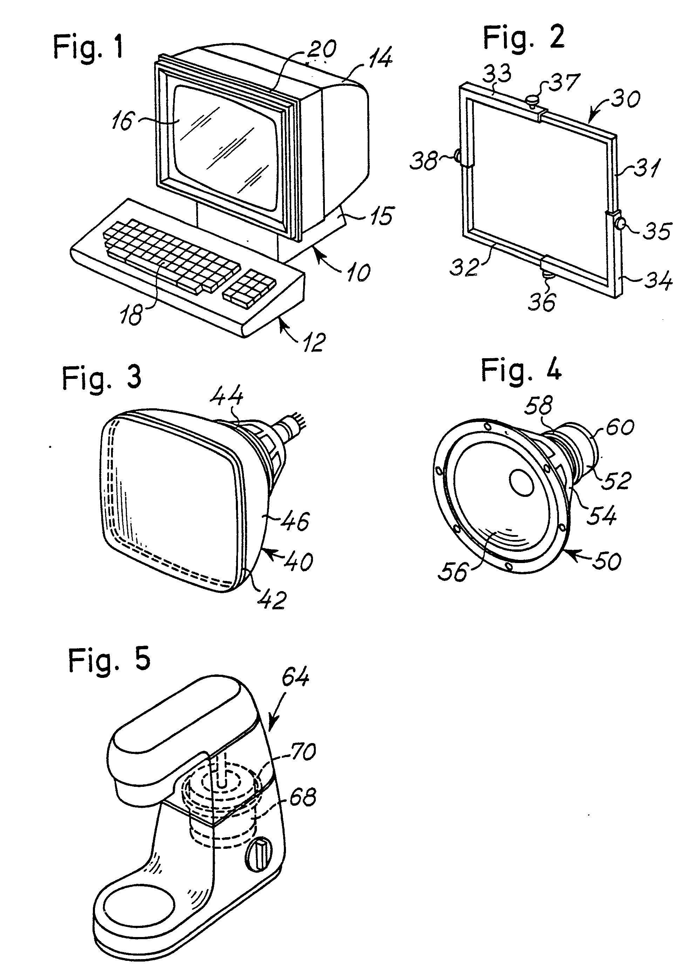

In Figure 1, a computer terminal is shown comprising a display unit 10 and a keyboard unit 12. The display unit 10 comprises a housing 14 arranged on top of a base 15 and in which a cathode-ray tube is included the front surface of which is designated the reference numeral 16. By means of individual keys 18 of the keyboard unit 12, an operator inputs alpha-numeric characters into the computer terminal for storing in a store thereof and for displaying on the front surface 16 of the display unit 10, as is well known in the art. The cathode-ray tube of the display unit includes an electron gun and deflection electrodes and deflector coils and constitutes a magnetic field source, which exposes the operator to a long-term magnetic field influence. In order to eliminate this influence and to protect the operator from the magnetic field influence, the display unit 10 is provided with a ring-shaped conductor 20 constituting a device according to the invention for eliminating the influence from the magnetic field generating source and for protecting the operator against the influence. The ring-shaped conductor 20 is preferably a solid aluminium body of a large sectional area such as 100 mm². In an alternative embodiment, the display unit 10 may constitute a display unit of a conventional television set. In this alternative embodiment, the keyboard unit 12 is omitted, and the display unit or the television set 10 is alternatively provided with channel-selector means etc., as is well known in the art.

In Figure 2, an accessory embodiment 30 of the device according to the invention is shown. The accessory embodiment 30 is basically adapted to be employed in connection with displays, i.e. display units of computer terminals or television sets, which do not include the device for eliminating the influence from the magnetic field generating source and for protecting the operator or a viewer such as the device 20 shown in Figure 1. The accessory embodiment 30 comprises two solid, L-shaped components 31 and 32, which are received in hollow, L-shaped components 33 and 34 together constituting a ring-shaped conductor in accordance with the teaching of the present invention. The solid, L-shaped components 31 and 32 are fixed and maintained in relation to the hollow, L-shaped components 33 and 34 by means of thumb screws 35, 36, 37 and 38. In use, the device 30 is arranged so as to encircle the housing of the cathode-ray tube unit in question, e.g. a display unit of a computer terminal or a television set, such as in an arrangement similar to the arrangement of the ring-shaped conductor 20 of the display unit 10 shown in Figure 1. As will be understood, the solid, L-shaped components 31 and 32 are displaced within the hollow L-shaped components 33 and 34, so as to make the entire device closely fit the outer perimeter of the display unit or television set in question. Thereafter, the L-shaped components, i.e. the solid, L-shaped components 31 and 32, and the hollow, L-shaped components 33 and 34, are maintained in relation to each other by means of the thumb screws 35, 36, 37 and 38.

In Figure 3, a cathode-ray tube 40 is shown in which two ring-shaped conductors 42 and 44 constitute the preferred embodiment of the device according to the present invention for eliminating the influence on a viewer or operator from the magnetic field generating source or sources of the cathode-ray tube. The ring-shaped conductors 42 and 44 are arranged at the front surface of the cathode-ray tube and at the deflection electrode or deflector coil area of the cathode-ray tube, respectively, and are integrally arranged in the housing 46 of the cathode-ray tube 40. The ring-shaped conductors 42 and 44 are of a material of high electrical conductivity such as silver, aluminium or, preferably, copper of a large sectional area, e.g. of more than 1.5 mm², such as 4 mm².

In Figure 4 an electrodynamic loudspeaker unit 50 is shown comprising a magnetic assembly 52 and a frame 54, in which a cone membrane 56 is arranged. From the magnetic assembly 52, a high magnetic field is radiated. In order to protect persons in the vicinity of the loudspeaker unit from the magnetic field generated by the magnetic assembly and radiated therefrom and, thus eliminate the influence from the magnetic field generating source of the loudspeaker unit on the persons in accordance with the teaching of the present invention, the loudspeaker unit 50 is provided with two ring-shaped conductors 58 and 60, which are arranged at the front end and the rear end of the magnetic assembly, respectively. As described above, the ring-shaped conductors are of a highly conductive material such as copper, aluminium or silver and of a fairly large sectional area such as 1—5 mm².

In Figure 5, a domestic apparatus, viz. a mixer 64 is shown. The mixer comprises a mixer housing 66, in which a drive unit or motor 68 is arranged, as shown in dotted line in Figure 5. In accordance with the teaching of the present invention, a ring-shaped conductor 70 is arranged so as to encircle the motor 68 of the mixer in order to eliminate the disease and illness causing effect from the magnetic field generated and radiated from the motor 68 of the mixer in accordance with the teaching of the present invention.

In Figures 1—5, the elimination and protection against the influence from a magnetic field generated and radiated from a magnetic field generating source is provided by means of a device according to the invention, which is arranged at the origin of the magnetic field, i.e. at the magnetic field generating source and so as to encircle the source, the elimination and protection against magnetic field generating sources may in accordance with the principles of the present invention further be accomplished by arranging a number of ring-shaped conductors between the magnetic field generating sources, either artificial or natural sources.

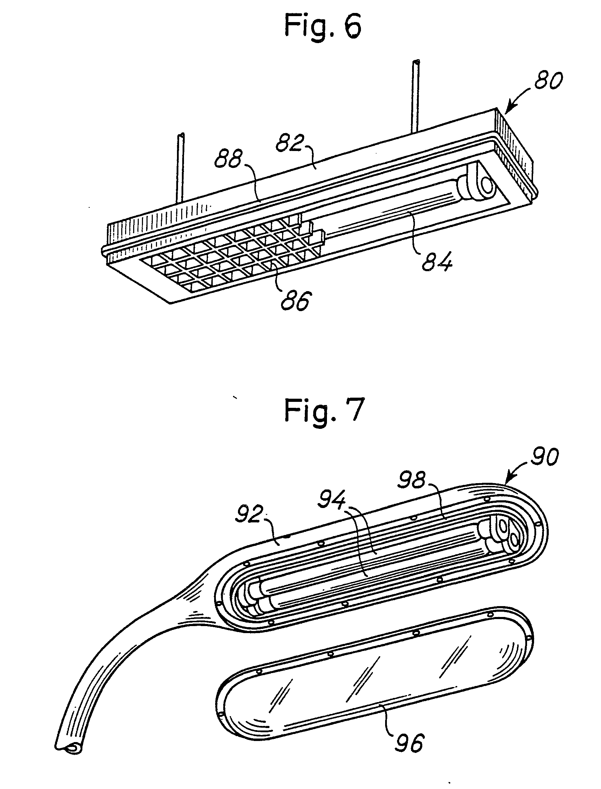

In Figure 6, a further implementation of the teaching of the present invention is shown. It is realized that a fluorescent lamp or tube in itself also constitutes a magnetic field radiating source. Thus, it is realized that a high radiation intensity is detected even when the lamp or tube is turned off. It is to be emphasized that the magnetic field radiation detected from fluorescent lighting fittings is not only radiated from the inductor of the fluorescence lighting fitting but also from the fluorescence tube or fluorescence lamp itself.

In Figure 6, a fluorescence lighting fitting is shown designated 80. The fitting includes a housing 82, in which a single fluorescence tube 84 is received within a recess. Below the fluorescence tube, a light diffusor 86 is arranged. Encircling the housing 82 of the fitting 80, a ring-shaped conductor 88 of a highly conductive material such as copper, aluminium or silver and of fairly large sectional area such as 1—5 mm², preferably 4 mm², is arranged.

In Figure 7, a lighting fitting for outdoor use is shown, basically of the above fluorescence lighting concept. The light fitting is designated 90 in its entirety and comprises a housing 92, in which two fluorescence tubes 94 are arranged. A light transparent dome or globe 96 is arranged below the fluorescence tubes 94 and fixed to the housing 92 by means of screws, not shown in Figure 8. Within the housing 92, a ring-shaped conductor 98 is arranged constituting a device according to the invention, and basically of a construction identical to the ring-shaped conductor 88, shown in Figure 6, i.e. of a highly conductive material such as copper, aluminium or silver and of a fairly large sectional area such 1—5 mm², preferably 4 mm².

It is to be understood that although the teaching of the present invention has been described with reference to fluorescence lighting fittings of the type adapted to receive fluorescence tubes, the teaching of the present invention is also adaptable to light sources of different types such as phosphorescence lamps, luminescence lamps, e.g. electroluminescence, chemi-luminescence, or tribo-luminescence lamps, etc., glow discharge lamps, cathode drop or cathode fall lamps and to some extent incandescent electric lamps or the like. It is also to be understood that lamps different from tubes such as lamps to be received in caps, bases or sockets such as screw, bayonet or pin caps, bases or sockets are also protectable in accordance with the teaching of the present invention.

Example

A fluorescence tube fitting, basically of the type described above with reference to Figure 6, was arranged in a garden of a single-family house. In a room adjacent to the garden, the radiation from the fluorescence tube fitting was registered. By arranging a copper conductor of a sectional area of 4 mm² and measuring 2.5 m×3 m on the house wall between the garden and the room of the house the radiation from the fitting in to the room was basically reduced to nil. In a further test, the dimensions of the copper conductor was increased to 2.5 m×5 m. In this test, the radiation from the fluorescence tube fitting into the room was also basically reduced to nil. The copper conductors of the above tests were enclosed in a plastic coating. The copper conductors were constituted by a flexible plastic coated electrical conductor. From the tests, it is concluded that the radiation from magnetic field sources may be reduced radically and even reduced to basically nil, if desired, by providing protecting devices in accordance with the teaching of the present invention.

Further tests involving computer terminals, TV-sets, household machines such as mixers, electric heaters, etc. have also proved that the teaching of the present invention renders it possible to protect persons and animals against the magnetic fields generated by different magnetic field generating and radiating sources.

Although the invention has been described with reference to a number of specific embodiments shown on the drawings, it is evident to the worker skilled in the art that several modifications and alternative embodiments are conceivable within the scope of the present invention. Thus, the ring-shaped conductor may be constituted by a metallic foil sheet, e.g. an aluminium foil sheet having an adhesive layer on one side surface thereof. It is believed that this aluminium foil is particularly applicable in connection with fluorescence tubes such as fluorescense tube fittings of the kind shown in Figures 6 and 7. Thus, the teaching of the present invention may advantageously be employed in conjunction with any magnetic field generating and radiating source in order to eliminate the influence from the source on any persons or animals exposed to the radiation from the magnetic field generating source. Thus, the teaching of the present invention may advantageously be employed within the building construction field in order to eliminate the influence on persons from artificial as well as natural magnetic field generating sources.

## Claims

1. A method of eliminating the influence on one or more persons or animals from electro-magnetic field generating source and of protecting said one or more persons or animals against the electro-magnetic field generated by the source so as to eliminate the effect of the source on said one or more persons or animals, characterized by arranging a closed loop conductor of high electrical conductivity so as to encircle the source, or alternatively,

arranging the closed loop conductor in a plane between the source and said one or more persons or animals to be protected.

2. A method according to claim 1, further comprising:

arranging a number of closed loop conductors together constituting a network in said plane.

3. A method according to claim 2, said number of closed loop conductors being connected to one another in electrically conductive relationship.

4. A method according to any of the preceding claims 1—3, said substantially closed loop conductor or each of said number of closed loop conductors defining a perimeter of less than 2 m, preferably less than 1.5 m, and being constituted by a copper conductor of a sectional area of more than 1.5 mm² such as 5 mm².

5. A method according to any of the claims 1—4, the source being an electrical apparatus or a component thereof, such as an electric motor or transformer, a cathode-ray tube of a television set or of a computer terminal, a domestic apparatus, such as a washing machine, a rotary dryer, an automatic dishwasher, a mixer, a vacuum cleaner, an electric heating apparatus, an electrodynamic loudspeaker unit, a light source, particularly a fluorescent light source, lamp or tube, or the like.

6. A device for carrying out the method according to any of claims 1 to 5, characterized by said closed loop conductor being constituted by a copper conductor of a sectional area of more than 1.5 mm² such as 5 mm².

7. A device according to claim 6, characterized by the source being an electrical apparatus or a component thereof, such as an electric motor or transformer, a cathode-ray tube of a television set or of a computer terminal, a domestic apparatus, such as a washing machine, a rotary dryer, an automatic dishwasher, a mixer, a vacuum cleaner, an electric heating apparatus, an electrodynamic loudspeaker unit, a light source, particularly a fluorescent light source, lamp or tube, or the like.

## Patentansprüche

1. Verfahren zum Eliminieren des Einflusses einer ein elektromagnetisches Feld erzeugenden Quelle auf eine Person, mehrere Personen oder Tiere und zum Schutz dieser Person, Personen oder Tiere gegen das elektromagnetische Feld einer solchen Quelle in der Weise, daß die Wirkung der Quelle auf diese Person, Personen oder Tiere eliminiert wird, gekennzeichnet durch eine geschlossene Leiterschleife hoher elektrischer Leitfähigkeit, die entweder die Quelle umschließt oder in einer Ebene zwischen der Quelle und der Person, den Personen oder den Tieren, die geschützt werden sollen, angeordnet ist.

2. Verfahren nach Anspruch 1, dadurch gekennzeichnet, daß mehrere geschlossene Leiterschleifen zusammengefaßt sind und in der Ebene ein Netzwerk bilden.

3. Verfahren nach Anspruch 2, dadurch gekennzeichnet, daß die geschlossenen Leiterschleifen elektrisch miteinander verbunden sind.

4. Verfahren nach einem der vorstehenden Ansprüche 1 bis 3, dadurch gekennzeichnet, daß die geschlossene Leiterschleife oder jede der geschlossenen Leiterschleifen einen Durchmesser von weniger als 2 m, vorzugsweise weniger als 1,5 m, hat und aus einem Kupferleiter mit einem Querschnitt von mehr als 1,5 mm², z.B. 5 mm², besteht.

5. Verfahren nach einem der Ansprüche 1 bis 4, dadurch gekennzeichnet, daß die Quelle ein elektrisches Gerät oder ein Teil davon ist, wie z.B. ein Elektromotor oder Transformator, eine Kathodenstrahlröhre eines Fernsehgerätes oder Computerterminals, ein Haushaltsgerät wie eine Waschmaschine, ein Rotationstrockner, ein automatischer Geschirrspüler, ein Mixer, ein Staubsauger, ein elektrisches Heizgerät, ein elektrodynamischer Lautsprecher, eine Lichtquelle, insbesondere eine Leuchtstofflampe oder -röhre o. dgl.

6. Vorrichtung zur Durchführung des Verfahrens nach einem der Ansprüche 1 bis 5, dadurch gekennzeichnet, daß die geschlossene Leiterschleife aus einem Kupferleiter mit einem, Querschnitt von mehr als 1,5 mm², z.B. 5 mm², besteht.

7. Vorrichtung nach Anspruch 6, dadurch gekennzeichnet, daß die Quelle ein elektrisches Gerät oder ein Teil davon ist, wie z.B. ein Elektromotor oder Transformator, eine Kathodenstrahlröhre eines Fernsehgerätes oder Computerterminals, ein Haushaltsgerät wie eine Waschmaschine, ein Rotationstrockner, ein automatischer Geschirrspüler, ein Mixer, ein Staubsauger, ein elektrisches Heizgerät, ein elektrodynamischer Lautsprecher, eine Lichtquelle, insbesondere eine Leuchtstofflampe oder -röhre o. dgl.

## Revendications

1. Procédé d'élimination de l'influence d'une source génératrice de champ électro-magnétique sur une ou plusieurs personnes ou animaux et de protection desdites personnes ou animaux contre le champ électro-magnétique engendré par la source de façon à éliminer l'effet de la source sur lesdites personnes ou animaux, caractérisé en ce qu'on dispose un conducteur de haute conductivité électrique en forme de boucle fermée de manière à encercler la source ou bien, en variante, on dispose le conducteur en forme de boucle fermée dans un plan situé entre la source et la ou les personnes ou animaux à protéger.

2. Un procédé selon la revendication 1, consistant en outre à associer plusieurs conducteurs en boucle fermée pour constituer un réseau dans ledit plan.

3. Un procédé selon la revendication 2, lesdits plusieurs conducteurs en boucle fermée étant reliés entre eux en relation de conduction de courant.

4. Un procédé selon une quelconque des revendications 1 à 3, ledit conducteur sensiblement en boucle fermée ou bien chacun desdits plusieurs conducteurs en boucle fermée définissant un périmètre inférieur à 2 m, de préférence inférieur à 1,5 m, et étant constitué par un conducteur un cuivre d'une section supérieurs à 1,5 mm², par example de 5 mm².

5. Un procédé selon une quelconque des revendications 1 à 4, la source étant un appareil électrique ou un composant de celui-ci, comme un moteur électrique ou un transformateur, un tube cathodique d'un appareil de télévision ou d'un terminal d'ordinateur, un appareil domestique, comme une machine à laver, un séchoir rotatif, un lave-vaisselle automatique, un mélangeur, un aspirateur, un appareil de chauffage électrique, un appareil à haut-parleur électrodynamique, une source lumineuse, en particulier une source de lumière fluorescente, une lampe ou un tube, ou analogues.

6. Un dispositif pour la mise en oeuvre du procédé selon une quelconque des revendications 1 à 5, caractérisé en ce que ledit conducteur en boucle fermée est constitué par un conducteur de cuivre d'une section supérieure à 1,5 mm², par exemple de 5 mm².

7. Un dispositif selon la revendication 6, caractérisé en ce que la source est un appareil électrique ou un composant de celui-ci, comme un moteur électrique ou un transformateur, un tube cathodique d'un appareil de télévision ou d'un terminal d'ordinateur, un appareil domestique, comme une machine à laver, un séchoir rotatif, un lave-vaisselle automatique, un mélangeur, un aspirateur, un appareil de chauffage électrique, un appareil à haut-parleur électrodynamique, une source lumineuse, en particulier une source de lumière fluorescente, une lampe ou un tube, ou analogues.

**Fig. 1**

**Fig. 2**

**Fig. 3**

**Fig. 4**

**Fig. 5**

# Fig. 6

# Fig. 7